# EUROPEAN PATENT APPLICATION

(11) **EP 4 142 446 A1**
(43) Date of publication of application: **01.03.2023**
(21) Application number: 21797412.0
(22) Date of filing: 28.04.2021
(51) Int. Cl.: H05K 7/20, G06F 1/20

(54) **ELECTRONIC DEVICE COMPRISING HEAT DISSIPATION STRUCTURE**

(30) Priority: 28.04.2020 KR 20200051559
(71) Applicant: Samsung Electronics Co., Ltd., Gyeonggi-do 16677 (KR)
(72) Inventor: KOO, Kyungha, Suwon-si Gyeonggi-do 16677 (KR); KIM, Jihong, Suwon-si Gyeonggi-do 16677 (KR); JUNG, Chunghyo, Suwon-si Gyeonggi-do 16677 (KR); JEONG, Chihwan, Suwon-si Gyeonggi-do 16677 (KR); CHUNG, Haein, Suwon-si Gyeonggi-do 16677 (KR)
(74) Representative: HGF
(86) International application number: PCT/KR2021/005356
(87) International publication number: WO 2021/221453

(57) **Abstract**

An electronic device comprises: a housing which includes an internal space defined by a first plate facing a first direction and a second plate facing a second direction opposite to the first direction; a printed circuit board placed in the internal space; a middle frame which is placed in proximity to the printed circuit board, between the first plate and the second plate; and a heat pipe which is affixed to the middle frame and an electronic component mounted on the printed circuit board, and which is placed in proximity to the printed circuit board, wherein the heat pipe may comprise: a first end portion in contact with the electronic component via a heat transfer material; a second end portion having the same body as the first end portion, and placed at the other end corresponding to the first end portion; a heat transfer part which is a pipeline in which a working fluid moves, and which connects the first end portion to the second end portion and has the same one body as the first end portion and the second end portion; and a mounting part which compresses a part of the pipeline, and while forming a curvature with the heat transfer part, is placed on a side surface of the heat transfer part and coupled to the middle frame. Various other embodiments identified from the present document are also possible.

## Description

### [Technical Field]

Various embodiments of the disclosure relate to an electronic device including a heat dissipation structure.

### [Background Art]

As technology advances, electronic devices like smartphones or tablet computers are continuously required to become thinner. Accordingly, various technologies for internal structures of electronic devices are actively developing in order to effectively solve heat generated from electronic components mounted in the electronic devices. For example, a heat pipe capable of absorbing heat generated from electronic components mounted in an electronic device may be mounted on a middle frame for maintaining stiffness of the electronic device.

### [Disclosure of Invention]

### [Technical Problem]

When a heat pipe is mounted on a middle frame, a separate seating plate may be required to mount the heat pipe on the middle frame. Accordingly, a separate assembly jig may be required to couple the seating plate to the heat pipe, and a manufacturing cost may increase due to the increase of manufacturing processes like operating a soldering oven for soldering at low temperature.

Various embodiments disclosed in the disclosure provide an electronic device including a heat dissipation structure having a separate seating structure formed therein to mount a heat pipe on a middle frame.

### [Solution to Problem]

According to various embodiments disclosed in the disclosure, an electronic device may include: a housing including an internal space which is formed by a first plate facing in a first direction, and a second plate facing in a second direction opposite to the first direction; a printed circuit board disposed in the internal space; a middle frame disposed in the internal space in the proximity of the printed circuit board; an electronic component mounted on the printed circuit board; and a heat pipe fixed to the middle frame and disposed in the proximity of the printed circuit board, and the heat pipe may include: a first end which is in contact with the electronic component through a heat transfer material; a second end which has the same body as the first end, and is disposed at the other end corresponding to the first end; a heat transfer part which includes a duct of a working fluid, connects the first end and the second end, and has the same one body as the first end and the second end; and a seating part which is formed by compressing a part of the duct, and while forming a curve with the heat transfer part, is disposed on a side surface of the heat transfer part and coupled to the middle frame.

In addition, according to various embodiments disclosed in the disclosure, an electronic device may include: a housing including an internal space which is formed by a first plate facing in a first direction, and a second plate facing in a second direction opposite to the first direction; a printed circuit board disposed in the internal space; a first support member disposed in the internal space in the proximity of the printed circuit board; an electronic component mounted on the printed circuit board; and a heat dissipation member fixed to the first support member and disposed in the proximity of the printed circuit board, and the heat dissipation member may include: a heat transfer part including a duct through which a working fluid absorbing thermal energy generated in the electronic component moves; and a seating part which is formed by compressing at least a certain area of at least one side surface of the heat dissipation member among areas except for the heat transfer part, and is coupled to the first support member.

In addition, according to various embodiments disclosed in the disclosure, a portable communication device may include: a housing including an internal space which is formed by a first plate facing in a first direction, and a second plate facing in a second direction opposite to the first direction; a printed circuit board disposed in the internal space; a middle frame disposed between the first plate and the second plate in the proximity of the printed circuit board; an electronic component mounted on the printed circuit board; and a heat pipe fixed to the middle frame and disposed in the proximity of the printed circuit board, and the heat pipe may include: a first end which is in contact with the electronic component through a heat transfer material; a second end which has the same body as the first end, and is disposed at the other end corresponding to the first end; a heat transfer part which is a duct to allow a working fluid to move therethrough, connects the first end and the second end, and has the same one body as the first end and the second end; and a seating part which is formed by compressing a part of the duct, and while forming a curve with the heat transfer part, is disposed on a side surface of the heat transfer part and coupled to the middle frame.

### [Advantageous Effects of Invention]

According to various embodiments disclosed in the disclosure, a heat pipe may include a seating part to be coupled with a middle frame.

In addition, according to various embodiments disclosed in the disclosure, a seating part may be formed on a heat pipe, so that a process for soldering a seating plate to an existing heat pipe is not required.

In addition, various effects that are directly or indirectly understood through the disclosure may be provided.

### [Brief Description of Drawings]

FIG. 1 is a perspective view illustrating a front surface of an electronic device according to an embodiment;
FIG. 2 is a perspective view illustrating a rear surface of the electronic device of FIG. 1;
FIG. 3 is an exploded perspective view of the electronic device of FIG. 1;
FIG. 4 is a top view illustrating a state in which a heat pipe is disposed in an electronic device according to various embodiments;
FIG. 5 is a cross-sectional view illustrating a state in which a heat pipe is coupled to a middle frame according to an embodiment;
FIG. 6 is another cross-sectional view illustrating a state in which a heat pipe is coupled to a middle frame according to an embodiment;
FIG. 7 is a perspective view illustrating a heat pipe having a curved shape according to an embodiment;
FIG. 8 is a cross-sectional view illustrating a state in which a seating part formed on one cross section of a heat pipe is coupled to a middle frame according to an embodiment;
FIG. 9 is another cross-sectional view illustrating a state in which a seating part formed one cross section of a heat pipe is coupled to a middle frame according to an embodiment;
FIG. 10 is a perspective view illustrating a state in which a seating part is formed at designated intervals on a heat pipe according to an embodiment; and
FIG. 11 is a perspective view illustrating a state in which a seating part is formed on a designated position of a heat pipe according to an embodiment.

### [Mode for Carrying out the Invention]

Various embodiments of the disclosure will be described herein below with reference to the accompanying drawings. However, these are not intended to limit the disclosure to specific embodiments, and should be understood as including various modifications, equivalents, and/or alternatives of embodiments of the disclosure. In explaining the drawings, similar reference numerals may be used for similar components.

An electronic device according to various embodiments of the disclosure may include at least one of, for example, a smartphone, a tablet personal computer (PC), a mobile phone, a video telephone, an electronic book (e-book) reader, a desktop PC, a laptop PC, a netbook computer, a workstation, a server, a personal digital assistant (PDA), a portable multimedia player (PMP), a Motion Picture Experts Group (MPEG-1 or MPEG-2) Audio Layer 3 (MP3) player, a mobile medical device, a cameras, or a wearable device (for example, smart glasses, a head-mounted-device (HMD), electronic apparel, an electronic bracelet, an electronic necklace, electronic appcessory, electronic tattoos, a smart mirror, or a smart watch).

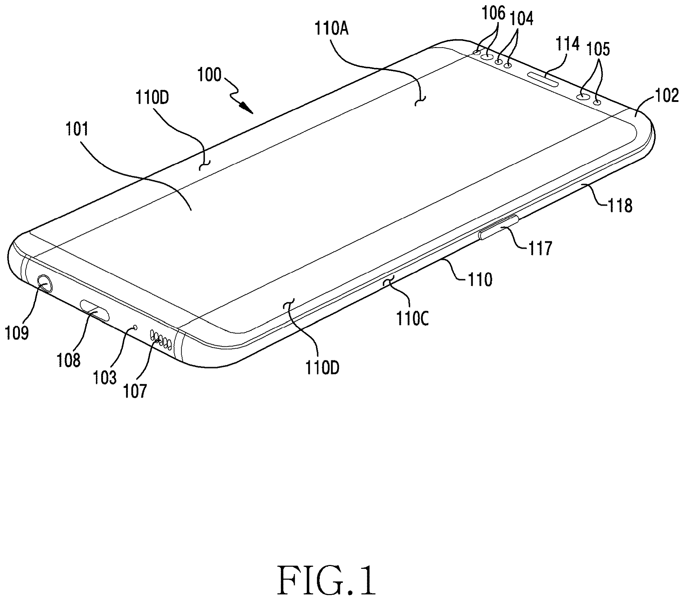

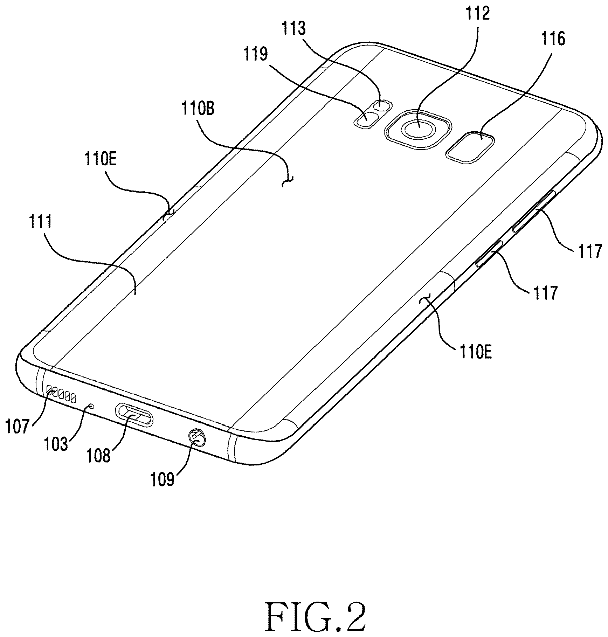

FIG. 1 is a perspective view of a front surface of an electronic device according to an embodiment. FIG. 2 is a perspective view of a rear surface of the electronic device of FIG. 1.

Referring to FIG. 1 and 2, the electronic device 100 according to an embodiment may include a housing 110 which includes a first surface (or a front surface) 110A, a second surface (or a rear surface) 110B, and a side surface 110C surrounding a space between the first surface 110A and the second surface 110B. In another embodiment (not shown), the housing may refer to a structure that forms a part of the first surface 110A, the second surface 110B, and the side surface 110C of FIG. 1. According to an embodiment, the first surface 110A may be formed by a front surface plate 102 having at least part substantially transparent (for example, a glass plate including various coating layers, or a polymer plate). The second surface 110B may be formed by a rear surface plate 111 which is substantially opaque. The rear surface plate 111 may be formed by, for example, coated or colored glass, ceramic, a polymer, metal (for example, aluminum, stainless steel (STS), or magnesium), or a combination of at least two of the above-mentioned materials. The side surface 110C may be formed by a side surface bezel structure 118 (or a "side surface member") which is coupled with the front surface plate 102 and the rear surface plate 111, and includes metal and/or a polymer. In a certain embodiment, the rear surface plate 111 and the side surface bezel structure 118 may be integrally formed with each other, and may include the same material (for example, a metallic material such as aluminum).

In the illustrated embodiment, the front surface plate 102 may include, on both ends of long edges of the front surface plate 102, two first areas 110D bent from the first surface 110A toward the rear surface plate 111 and seamlessly extended. In the illustrated embodiment (see FIG. 2), the rear surface plate 111 may include, on both ends of long edges, two second areas 110E bent from the second surface 110B toward the front surface plate 102 and seamlessly extended. In a certain embodiment, the front surface plate 102 (or the rear surface plate 111) may include only one of the first areas 110D (or the second areas 110E). In another embodiment, a part of the first areas 110D or the second areas 110E may not be included. In the above-described embodiments, when viewed from a side surface of the electronic device 100, the side surface bezel structure 118 may have a first thickness (or width) on a side surface that does not include the first areas 110D or the second areas 110E described above, and may have a second thickness thinner than the first thickness on a side surface that includes the first areas 110D or the second areas 110E.

According to an embodiment, the electronic device 100 may include at least one of a display 101, audio modules 103, 107, 114, sensor modules 104, 116, 119, camera modules 105, 112, a key input device 117, a light emitting element 106, and connector holes 108, 109. In a certain embodiment, the electronic device 100 may omit at least one of the components (for example, the key input device 117 or the light emitting element 106) or may additionally include other components.

The display 101 may be exposed through a substantial portion of the front surface plate 102, for example. In a certain embodiment, at least part of the display 101 may be exposed through the front surface plate 102 forming the first surface 110A and the first areas 110D of the side surface 110C. In a certain embodiment, a corner of the display 101 may be formed substantially the same as a shape of an outside border of the front surface plate 101 adjacent thereto. In another embodiment (not shown), a gap between an outside border of the display 101 and an outside border of the front surface plate 102 may be formed substantially the same to extend an exposed area of the display 101.

In another embodiment (not shown), a recess or an opening may be formed on a part of a screen display area of the display 101, and the electronic device may include at least one of the audio module 114, the sensor module 104, the camera module 105, and the light emitting element 106 aligned with the recess or the opening. In another embodiment (not shown), the electronic device may include, on a rear surface of the screen display area of the display 101, at least one of the audio module 114, the sensor module 104, the camera module 105, a fingerprint sensor 116, and the light emitting element 106. In another embodiment (not shown), the display 101 may be coupled with or may be disposed adjacent to a touch sensing circuit, a pressure sensor for measuring an intensity (pressure) of a touch, and/or a digitizer for detecting a stylus pen of a magnetic field method. In a certain embodiment, at least part of the sensor modules 104, 119, and/or at least part of the key input device 117 may be disposed on the first areas 110D and/or the second areas 110E.

The audio modules 103, 107, 114 may include a microphone hole 103 and speaker holes 107, 114. The microphone hole 103 may have a microphone disposed therein to acquire an external sound, and in a certain embodiment, the microphone hole may have a plurality of microphones disposed therein to detect a direction of a sound. The speaker holes 107, 114 may include an external speaker hole 107 and a receiver hole 114 for calling. In a certain embodiment, the speaker holes 107, 114 and the microphone hole 103 may be implemented as one hole or a speaker may be included without the speaker holes 107, 114 (for example, a piezo speaker).

The sensor modules 104, 116, 119 may generate an electric signal or a data value corresponding to an internal operation state or an external environment state of the electronic device 100. The sensor modules 104, 116, 119 may include, for example, a first sensor module 104 (for example, a proximity sensor) and/or a second sensor module (not shown) (for example, a fingerprint sensor) disposed on the first surface 110A of the housing 110, and/or a third sensor module 119 (for example, an HRM sensor) and/or a fourth sensor module 116 (for example, a fingerprint sensor) disposed on the second surface 110B of the housing 110. The fingerprint sensor may be disposed not only on the first surface 110A of the housing 110 (for example, the display 101), but also on the second surface 110B. The electronic device 100 may further include a sensor module (not shown), for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 104.

The camera modules 105, 112 may include a first camera device 105 disposed on the first surface 110A of the electronic device 100, and a second camera device 112 and/or a flash 113 disposed on the second surface 110B. The camera devices 105, 112 may include one or a plurality of lenses, an image sensor, and/or an image signal processor. The flash 113 may include, for example, a light emitting diode or a xenon lamp. In a certain embodiment, two or more lenses (an infrared camera, a wide-angle lens and a telephoto lens), or image sensors may be disposed on one surface of the electronic device 100.

The key input device 117 may be disposed on the side surface 110C of the housing 110. In another embodiment, the electronic device 100 may not include a part or an entirety of the key input device 117 mentioned above, and the key input device 117 that is not included may be implemented on the display 101 in other forms like a soft key. In a certain embodiment, the key input device may include the sensor module 116 disposed on the second surface 110B of the housing 110.

The light emitting element 106 may be disposed on the first surface 110A of the housing 110, for example. For example, the light emitting element 106 may provide state information of the electronic device 100 in the form of light. In another embodiment, the light emitting element 106 may provide a light source interlocking with an operation of the camera module 105. The light emitting element 106 may include, for example, a light emitting diode (LED), an infrared LED (IR LED), and a xenon lamp.

The connector holes 108, 109 may include a first connector hole 108 to accommodate a connector (for example, a USB connector) for exchanging power and/or data with an external electronic device, and/or a second connector hole (for example, an earphone jack) 109 to accommodate a connector for exchanging an audio signal with an external electronic device.

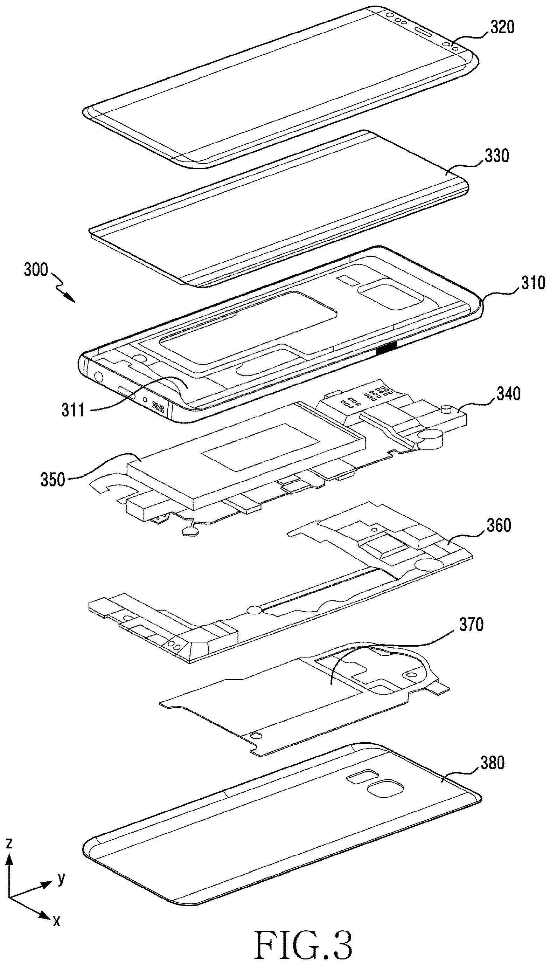

FIG. 3 is an exploded perspective view of the electronic device of FIG. 1.

Referring to FIG. 3, the electronic device 300 may include a side surface bezel structure 310, a first support member 311 (for example, a bracket), a front surface plate 320, a display 330, a printed circuit board 340, a battery 350, a second support member 360 (for example, a rear case), an antenna 370, and a rear surface plate 380. In a certain embodiment, the electronic device 300 may omit at least one (for example, the first support member 311 or the second support member 360) of the components, or may additionally include other components. At least one of the components of the electronic device 300 may be the same as or similar to at least one of the components of the electronic device 100 of FIG. 1 or 2, and a redundant explanation thereof is omitted.

The first support member 311 may be disposed inside the electronic device 300 to be connected with the side surface bezel structure 310, or may be integrally formed with the side surface bezel structure 310. For example, the first support member 311 may be formed with a metallic material and/or a nonmetallic material (for example, a polymer). The first support member 311 may have one surface coupled with the display 330 and the other surface coupled with the printed circuit board 340. A processor, a memory, and/or an interface may be mounted on the printed circuit board 340. The processor may include, for example, one or more of a central processing device, an application processor, a graphic processing device, an image signal processor, a sensor hub processor, or a communication processor.

The memory may include, for example, a volatile memory or a nonvolatile memory.

The interface may include, for example, a high definition multimedia interface (HDMI), a universal serial bus (USB) interface, a secure digital (SD) card interface, and/or an audio interface. The interface may electrically or physically connect the electronic device 300 with an external electronic device, and may include a USB connector, an SD card/MMC connector, or an audio connector.

The battery 350 may be a device that supplies power to at least one component of the electronic device 300, and may include, for example, a primary battery which is not rechargeable or a secondary battery which is rechargeable, or a fuel cell. At least part of the battery 350 may be disposed substantially on the same plane as the printed circuit board 340, for example. The battery 350 may be integrally disposed inside the electronic device 300, and may be attachably and detachably disposed in the electronic device 300.

The antenna 370 may be disposed between the rear surface plate 380 and the battery 350. The antenna 370 may include, for example, a near field communication (NFC) antenna, a wireless charging antenna, and/or a magnetic secure transmission (MST) antenna. The antenna 370 may perform short-range communication with an external device, or may wirelessly transmit and receive power necessary for charging. In another embodiment, an antenna structure may be formed by a part of the side surface bezel structure 310 and/or the first support member 311, or a combination thereof.

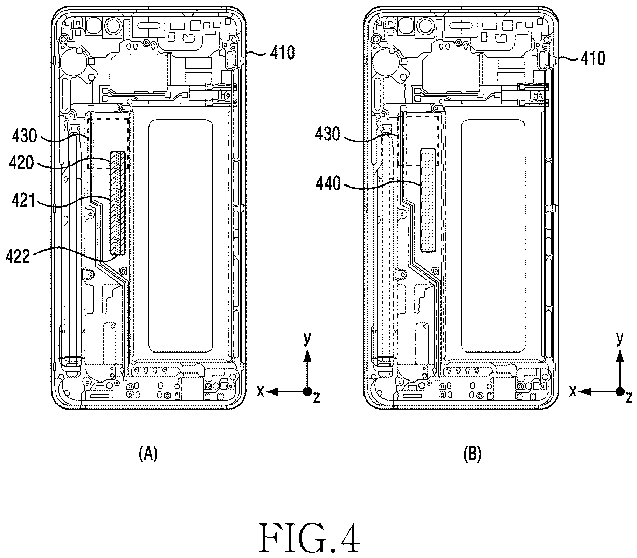

FIG. 4 is a top view illustrating a state in which a heat pipe is disposed in an electronic device according to various embodiments.

Referring to (a) of FIG. 4, the electronic device 400 (for example, the electronic device 100) according to various embodiments may include a middle frame 410 (for example, the first support member 311 of FIG. 3) for mounting a heat pipe 440 to dissipate thermal energy generated in a plurality of electronic components mounted in the electronic device 400 to an external area.

According to an embodiment, the heat pipe 440 and the middle frame 410 may be disposed in an internal space of a housing (for example, the housing 110 of FIG. 1) formed by a first plate (for example, the first surface 110A of FIG. 1) and a second plate (for example, the second surface 110B of FIG. 1).

According to an embodiment, the middle frame 410 may be disposed, as a layer structure, in the proximity of a printed circuit board (for example, the printed circuit board 340 of FIG. 3) disposed in the housing. For example, the middle frame 410 may be positioned on an upper surface (for example, a surface of the +z axis direction) of the printed circuit board. The heat pipe 440 mounted on the middle frame 410 may be in contact with an electronic component mounted on the printed circuit board through a heat transfer material.

According to an embodiment, the middle frame 410 may include a fixing part 420 for mounting the heat pipe 440. For example, the middle frame 410 may include the fixing part 420 positioned on a surface thereof (for example, a surface in the -z axis direction) facing the printed circuit board.

The fixing part 420 may be an area into which the heat pipe 440 is inserted or mounted, and may include a coupling part 421 and an accommodation part 422. The fixing part 420 may be positioned on a certain area of the middle frame 410 to be oriented in a longitudinal axis direction (for example, a longitudinal direction) (for example, the +y axis direction). The coupling part 421 may be an area on which a seating part included in the heat pipe 440 is seated. The accommodation part 422 may include an area that accommodates a heat transfer part included in the heat pipe 440 when the seating part of the heat pipe 440 is coupled to the coupling part 421. For example, the coupling part 421 and the accommodation part 422 may form a curve in the form of " " 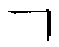 " or " 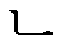 " in order to mount the heat pipe 440.

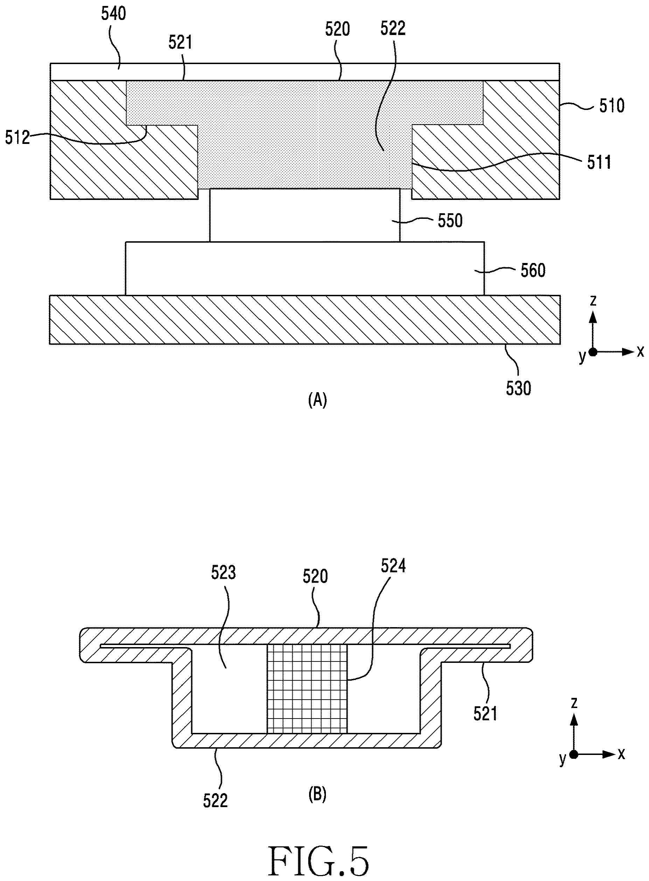

According to an embodiment, the coupling part 421 may be formed in a structure corresponding to the seating part included in the heat pipe 440 in order to mount the heat pipe 440 on the middle frame 410. The accommodation part 422 may be a space included in the coupling part 421, and may accommodate the heat transfer part which includes a duct through which a working fluid moves in the heat pipe 440. The seating part and the heat transfer part will be described in detail in FIG. 5.

Referring to (b) of FIG. 4, the heat pipe 440 may be mounted on the fixing part 420 included in the middle frame 410 in order to reinforce stiffness of the electronic device 400.

The heat pipe 440 may be mounted on the middle frame 410 to have one end (for example, a first end, an end in the +y axis direction) thereof disposed in the proximity of an area 430 where the plurality of electronic components are mounted. For example, the middle frame 410 may be disposed, as a layered structure, in the internal space of the electronic device 400, while being spaced apart from the upper surface of the printed circuit board by a predetermined distance or longer. In another example, when the heat pipe 440 is mounted on the middle frame 410, the one end of the heat pipe 440 may be disposed in the proximity of, but spaced apart from, the area 430 where a processor mounted on the upper surface of the printed circuit board is positioned (for example, the area 430 where one of the plurality of electronic components is disposed), by a predetermined distance.

According to an embodiment, the one end may be in contact with an electronic component (for example, the processor) mounted on the printed circuit board 530 through a heat transfer material. The heat transfer material may be a thermally conductive material for transferring thermal energy generated in the electronic component to the heat pipe 440. The heat transfer material may be a semisolid material of a paste type.

According to an embodiment, the heat pipe 440 may absorb thermal energy generated in the plurality of electronic components through the heat transfer material of the one end. The heat pipe 440 may dissipate the absorbed thermal energy through the other end (for example, a second end, an end in the -y axis direction) corresponding to the one end. An area where the other end through which the thermal energy is dissipated is positioned may be a low-temperature area through which the absorbed thermal energy is dissipated. That is, the other end of the heat pipe 440 may be disposed on a low-temperature area which is spaced apart from the area where the thermal energy is generated by a predetermined distance or longer. For example, the heat pipe 440 may be disposed in the proximity of the processor mounted on the printed circuit board while being mounted on the middle frame 410. The heat pipe 440 may dissipate, through the other end disposed in the low-temperature area while being spaced apart from the one end, the thermal energy absorbed from the processor through the one end. That is, the heat pipe 440 may be a heat transfer path or a heat transfer diffusion path, or may be a heat dispersing path.

The heat pipe 440 according to various embodiments may be disposed in the proximity of the plurality of electronic components on some areas of the remaining areas except for the areas of the one end and the other end. A position where the heat pipe 440 is disposed may be changed according to a design structure as long as the heat pipe 440 is able to absorb thermal energy generated in the plurality of electronic components included in the electronic device 400 and to dissipate to the low-temperature area. For example, a part of the heat pipe 440 may be disposed in the proximity of the area where the plurality of electronic components are mounted, and the other part may be disposed in the low-temperature area which has a lower temperature than that of the area where the plurality of electronic components are mounted.

According to an embodiment, the heat pipe 440 may diffuse thermal energy absorbed at the one end toward a surrounding area of the heat pipe 440, and may disperse the thermal energy away from the center of the heat pipe 440. A diffusion rate of the absorbed thermal energy may be changed according to a thermal conductivity of a material forming the heat pipe 440.

FIG. 5 is a cross-sectional view illustrating a state in which a heat pipe is coupled to a middle frame according to an embodiment.

Referring to (a) of FIG. 5, the electronic device (for example, the electronic device 400 of FIG. 4) may include therein a middle frame 510 (for example, the middle frame 410 of FIG. 4), a heat pipe 520 (for example, the heat pipe 440 of FIG. 4), a printed circuit board 530 (for example, the printed circuit board 340 of FIG. 3), a display 540 (for example, the display 101 of FIG. 1 or the display 330 of FIG. 3), a heat transfer material 550, an electronic component 560. The components included in the electronic device are not limited thereto, and the electronic device may further include a key input device (for example, the key input device 115 of FIG. 1) when necessary.

According to an embodiment, the heat pipe 520 may be mounted on the middle frame 510 disposed in the electronic device.

According to an embodiment, the display 540 (for example, the display 101 of FIG. 1 or the display 330 of FIG. 3) may be disposed on an upper surface of the middle frame 510 disposed in the electronic device as a layered structure.

According to an embodiment, the heat pipe 520 may be disposed such that a heat transfer part 522 included in the heat pipe 520 faces the printed circuit board 530 disposed in the proximity of a lower surface (for example, a surface in the -z axis direction) of the middle frame 510.

According to an embodiment, the heat pipe 520 may be mounted on a fixing part (for example, the fixing part 420 of FIG. 4) of the middle frame 510 to be disposed in the proximity of the electronic component 560 mounted on the printed circuit board 530. A position relationship between the middle frame 510 and the printed circuit board 5310 may be changed, and the electronic component 560 may include a processor, a memory, and a plurality of sensor modules, but is not limited thereto.

According to an embodiment, the heat pipe 520 may absorb thermal energy generated in the electronic component 560 mounted on the printed circuit board 530 through the heat transfer material 550 in the proximity of the printed circuit board 530.

According to an embodiment, the heat pipe 520 may include a seating part 521 and the heat transfer part 522 in order to be mounted on the middle frame 510. The seating part 521 may have the same body as the heat transfer part 522, and may be mounted on a coupling part 512 (for example, the coupling part 421 of FIG. 4) of the middle frame 510. A curve may be formed on the seating part 521 to include a designated angle (for example, 90 degrees) with the heat transfer part 522.

According to an embodiment, the seating parts 521 positioned on both side surfaces of the heat transfer part 522 may be formed by compressing a part of the heat transfer part 522. The seating part 521 positioned on a side surface (for example, a surface in the +x axis and/or -x axis direction) of the heat transfer part 522 may have a thickness (for example, a second thickness) which is thinner than a thickness (for example, a first thickness) of the heat transfer part 522. For example, when the thickness of the heat transfer part 522 is 8 mm, the thickness of the seating part 521 may be 2 mm. The seating part 521 may not have a form of a duct, which is different from the heat transfer part 522, and may be formed by compressing a part of the upper surface (for example, the surface in the +z axis direction) of the heat transfer part 522 and a part of the lower surface (for example, the surface in the -z axis direction) to come into contact with each other.

According to an embodiment, the seating part 521 may not perform a function of transferring thermal energy absorbed at one end (for example, the first end) of the heat transfer part 522 to the other end (for example, the second end), and may be configured to couple the heat pipe 520 to the coupling part 512. That is, the heat pipe 520 may not have a separate seating plate soldered thereto, and may include a seating structure (for example, the seating part 521) for seating the heat pipe 520 on the middle frame.

According to another embodiment, the seating part 521 may diffuse thermal energy absorbed at one end of the heat pipe 520 toward a surrounding area from the heat pipe 520, according to a thermal conductivity of a material forming the heat pipe 520.

According to an embodiment, the heat transfer part 522 may be inserted into an area (for example, a hole) that is formed by an accommodation part 511 (for example, the accommodation part 422 of FIG. 4) of the middle frame 510.

The heat transfer part 522 may be a duct that allows a working fluid to move therethrough, and may be a duct that has the same body as one end (for example, one end in the +y axis direction of FIG. 4) and the other end (for example, the other end in the -y axis direction of FIG. 4) of the heat pipe 520, and connects one end and the other end.

According to an embodiment, when the seating part 521 is coupled to the coupling part 512, the heat transfer part 522 may be inserted into the area formed by the accommodation part 511 of the middle frame 510. The heat transfer part may be inserted into the area formed by the accommodation part 511 to absorb thermal energy generated in the electronic component 560 mounted on the printed circuit board 530. For example, the heat transfer part 522 may absorb thermal energy generated in a processor, a sensor module through the heat transfer material 550.

Referring to (b) of FIG. 5, the heat transfer part 522 may include a vapor channel 523 and a wick 524. The heat transfer part 522 may include a working fluid circulating in the heat pipe 520. The working fluid may include one of ammonia, methanol, ethanol, water, but is not limited thereto as long as the working fluid is able to perform the function of the heat pipe 520 in the heat transfer part 522. According to an embodiment, the working fluid in the heat pipe 520 may be moved not only by a capillary force but also by the gravity, centripetal force, electrostatic force, magnetism, and osmotic pressure, but is not limited thereto.

According to an embodiment, the vapor channel 523 may be a duct that, when the working fluid in a liquid state absorbs thermal energy generated in the electronic component 560 mounted on the printed circuit board 530 through the one end, allows the working fluid changed to a gaseous state to move therethrough.

According to an embodiment, the wick 524 may be a porous structure capable of generating the capillary force in the heat transfer part 522. The working fluid may move in a liquid state through the wick 524. For example, the wick 524 may be formed with a fine metal mesh, and may be a passage that is attached to or formed on some area in the heat pipe 520 to allow the working fluid in the liquid state to move therethrough.

According to an embodiment, the inside of the heat transfer part 522 may be in a vacuum state, and, when thermal energy is absorbed at one end of the heat pipe 520, the working fluid may absorb the thermal energy and may vaporize. The working fluid in the gaseous state may be moved to the other end through the vapor channel 523 by a steam pressure generated in the heat pipe 520. The working fluid in the gaseous state may be moved to the other end and may dissipate the thermal energy. The other end may be disposed on a low-temperature area to absorb the thermal energy owned by the working fluid in the gaseous state and to change the state of the working fluid from the gaseous state to a liquid state.

According to an embodiment, the working fluid in the gaseous state may be moved to the other end of the heat pipe 520 by the steam pressure. The working fluid in the gaseous state may be moved to the other end, thereby dissipating the thermal energy. The working fluid which dissipates the thermal energy may be changed to the liquid state, and may be moved to the one end through the wick 524 by the capillary force.

According to an embodiment, the seating part 521 may be formed by a remaining width of the heat pipe 520 except for a designated width forming the heat transfer part 522. The seating part 521 and the heat transfer part 522 may be formed by pressing a circular pipe. The widths of the seating part 521 and the heat transfer part 522 of the heat pipe 520 may be determined according to an outer diameter of the circular pipe. The seating part 521 may be formed by compressing the remaining width of the heat pipe 520 except for the heat transfer part 522 having the designated width. Accordingly, a width of the vapor channel 523 positioned in the heat pipe 520 may be reduced. That is, the seating part 521 may be configured with a designated width by considering the width of the vapor channel 523 or a tolerance of an attachment position of the wick 524.

For example, referring to table 1 presented below, when the width of the wick 524 is between 2 and 3 mm, the width of the seating part 521 may be determined to be between 0.32 mm and 3.2 mm inclusive. However, when a bonding strength of the seating part 521 and the coupling part 512 is considered, the width of the seating part 521 may be at least 2 mm or more. That is, when the width of the seating part 521 is at least 2 mm or more, the heat pipe 520 may be formed by using a circular pipe that has an outer diameter of 8 mm or more.

**[Table 1]**

| OD | Wₜₒₜₐₗ | t_{wall}x2 | W_{wick} | W_{vapor_no wing} | W_{wing} | W_{vapor_w wing} |
|---|---|---|---|---|---|---|
| 5 | 7.8 | 0.16 | 3 | 2.32 | 0.32 | 2 |
| | 7.8 | 0.16 | 2.5 | 2.57 | 0.57 | 2 |
| | 7.8 | 0.16 | 2 | 2.82 | 0.82 | 2 |
| 6 | 9.5 | 0.2 | 3 | 3.15 | 1.15 | 2 |
| | 9.5 | 0.2 | 2.5 | 3.40 | 1.4 | 2 |
| | 9.5 | 0.2 | 2 | 3.65 | 1.65 | 2 |
| 8 | 12.6 | 0.2 | 3 | 4.70 | 2.7 | 2 |
| | 12.6 | 0.2 | 2.5 | 4.95 | 2.95 | 2 |
| | 12.6 | 0.2 | 2 | 5.20 | 3.2 | 2 |

According to various embodiments described above, an electronic device (for example, the electronic device 101 of FIG. 1) may include: a housing including an internal space which is formed by a first plate (for example, the front surface plate 102 of FIG. 1) facing in a first direction, and a second plate (for example, the rear surface plate 111 of FIG. 1) facing in a second direction opposite to the first direction; a printed circuit board (for example, the printed circuited board 340 of FIG. 3 or the printed circuit board 530 of FIG. 5) disposed in the internal space; a middle frame (for example, the first support member 311 of FIG. 3 or the middle frame 510 of FIG. 5) disposed between the first plate and the second plate in the proximity of the printed circuit board; an electronic component (for example, the electronic component 560 of FIG. 5) mounted on the printed circuit board; and a heat pipe (for example, the heat pipe 440 of FIG. 4) fixed to the middle frame and disposed in the proximity of the printed circuit board, and the heat pipe may include: a first end which is in contact with the electronic component through a heat transfer material (for example, the heat transfer material 550 of FIG. 5); a second end which has the same body as the first end, and is disposed at the other end corresponding to the first end; a heat transfer part (for example, the heat transfer part 522 of FIG. 5) which is a duct to allow a working fluid to move therethrough, connects the first end and the second end, and has the same one body as the first end and the second end; and a seating part (for example, the seating part 521 of FIG. 5) which is formed by compressing a part of the duct, and while forming a curve with the heat transfer part, is disposed on a side surface of the heat transfer part and coupled to the middle frame.

According to various embodiments, the seating part may have a second thickness which is thinner than a first thickness of the heat transfer part, and may include a remaining width of the heat pipe except for a designated width forming the heat transfer part.

According to various embodiments, the middle frame may include a fixing part (for example, the fixing part 420 of FIG. 4) disposed on a designated surface thereof facing the printed circuit board to allow the seating part to be coupled thereto.

According to various embodiments, the fixing part may include a coupling part (for example, the coupling part 421 of FIG. 4 or the coupling part 512 of FIG. 5) to which the seating part is coupled; and an accommodation part (for example, the accommodation part 422 of FIG. 4 or the accommodation part 511 of FIG. 5) to accommodate the heat transfer part.

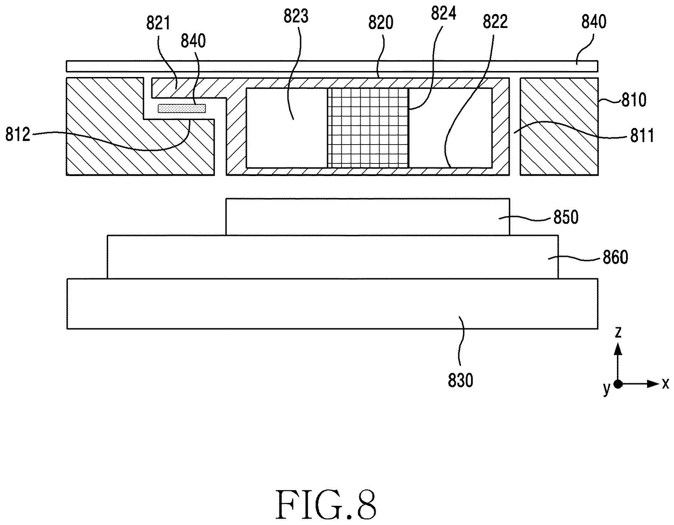

According to various embodiments, the electronic device may further include an adhesive layer (for example, the adhesive layer 840 of FIG. 8) disposed between the seating part and a part of the coupling part to bond the seating part to the coupling part.

According to various embodiments, the seating part may not allow the working fluid to move therethrough, and may diffuse absorbed thermal energy according to a thermal conductivity of a material forming the heat pipe.

According to various embodiments, the heat transfer material may include a material of a paste type.

According to various embodiments, when at least a certain area of the heat pipe is curved, the heat transfer part may be formed by compressing an area except for the curved part of the heat pipe.

According to various embodiments, the seating part may be formed on one side surface of both side surfaces of the heat pipe.

According to various embodiments, the seating parts may be formed at designated intervals on the heat pipe.

According to various embodiments, the working fluid may vaporize by thermal energy absorbed through the first end, and in this state, may move to the second end, and may dissipate the absorbed thermal energy at the second end and may be moved to the first end in a liquid state.

According to various embodiments as described above, an electronic device (for example, the electronic device 101 of FIG. 1) may include: a housing including an internal space which is formed by a first plate (for example, the front surface plate 102 of FIG. 1) facing in a first direction, and a second plate (for example, the rear surface plate 111 of FIG. 1) facing in a second direction opposite to the first direction; a printed circuit board (for example, the printed circuit board 340 of FIG. 3 or the printed circuit board 530 of FIG. 5) disposed in the internal space; a first support member (for example, the first support member 311 of FIG. 3 or the middle frame 510 of FIG. 5) disposed between the first plate and the second plate in the proximity of the printed circuit board; an electronic component (for example, the electronic component 560 of FIG. 5) mounted on the printed circuit board; and a heat dissipation member (for example, the heat pipe 440 of FIG. 4) fixed to the first support member and disposed in the proximity of the printed circuit board, and the heat dissipation member may include: a heat transfer part (for example, the heat transfer material 550 of FIG. 5) which is a duct through which a working fluid absorbing thermal energy generated in the electronic component moves; and a seating part (for example, the seating part 521 of FIG. 5) which is formed by compressing at least a certain area of at least one side surface of the heat dissipation member among areas except for the heat transfer part, and is coupled to the first support member.

According to various embodiments, the seating part may have a second thickness which is thinner than a first thickness of the heat transfer part, and may form a curve along with the heat transfer part.

According to various embodiments, the first support member may include a fixing part (for example, the fixing part 420 of FIG. 4) disposed on a designated surface thereof facing the printed circuit board to allow the seating part to be coupled thereto.

According to various embodiments, the fixing part may include a coupling part (for example, the coupling part 421 of FIG. 5 or the coupling part 512 of FIG. 5) to which the seating part is coupled; and an accommodation part (for example, the accommodation part 422 of FIG. 4 or the accommodation part 511 of FIG. 5) to accommodate the heat transfer part.

According to various embodiments, the electronic device may further include an adhesive layer (for example, the adhesive layer 840 of FIG. 8) disposed between the seating part and a part of the coupling part to bond the seating part to the coupling part.

According to various embodiments, the seating part may not allow the working fluid to move therethrough, and may diffuse absorbed thermal energy according to a thermal conductivity of a material forming the heat dissipation member.

According to various embodiments, when at least a certain area of the heat dissipation member is curved, the heat transfer part may be formed by compressing an area except for the curved part of the heat dissipation member.

According to various embodiments described above, a portable communication device (for example, the electronic device 101 of FIG. 1) may include: a housing including an internal space which is formed by a first plate (for example, the front surface plate 102 of FIG. 1) facing in a first direction, and a second plate (for example, the rear surface plate 111 of FIG. 1) facing in a second direction opposite to the first direction; a printed circuit board (for example, the printed circuited board 340 of FIG. 3 or the printed circuit board 530 of FIG. 5) disposed in the internal space; a middle frame (for example, the first support member 311 of FIG. 3 or the middle frame 510 of FIG. 5) disposed between the first plate and the second plate in the proximity of the printed circuit board; an electronic component (for example, the electronic component 560 of FIG. 5) mounted on the printed circuit board; and a heat pipe (for example, the heat pipe 440 of FIG. 4) fixed to the middle frame and disposed in the proximity of the printed circuit board, and the heat pipe may include: a first end which is in contact with the electronic component through a heat transfer material (for example, the heat transfer material 550 of FIG. 5); a second end which has the same body as the first end, and is disposed at the other end corresponding to the first end; a heat transfer part (for example, the heat transfer part 522 of FIG. 5) which is a duct to allow a working fluid to move therethrough, connects the first end and the second end, and has the same one body as the first end and the second end; and a seating part (for example, the seating part 521 of FIG. 5) which is formed by compressing a part of the duct, and while forming a curve with the heat transfer part, is disposed on a side surface of the heat transfer part and coupled to the middle frame.

According to various embodiments, the seating part may have a second thickness which is thinner than a first thickness of the heat transfer part, and may include a remaining width of the heat pipe except for a designated width forming the heat transfer part.

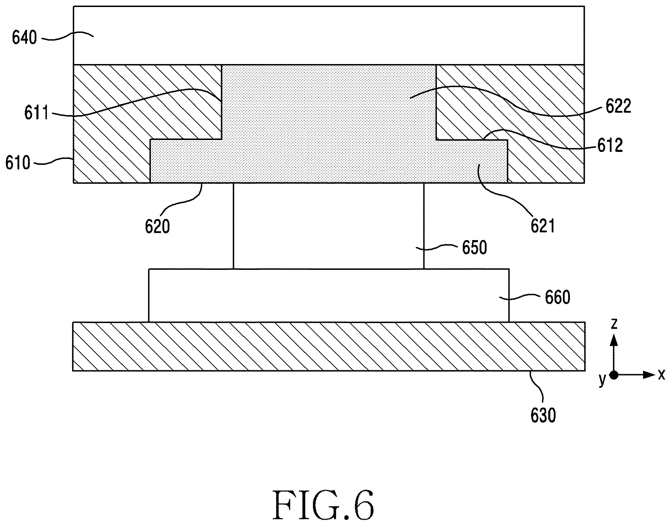

FIG. 6 is another cross-sectional view illustrating a state in which a heat pipe is coupled to a middle frame according to an embodiment.

Referring to FIG. 6, the heat pipe 620 (for example, the heat pipe 440 of FIG. 4) may be mounted on the middle frame 610 (for example, the middle frame 410 of FIG. 4) disposed in the electronic device (for example, the electronic device 400 of FIG. 4).

According to an embodiment, the middle frame 610 may be disposed to have a display 640 (for example, the display 101 of FIG. 1 or the display 330 of FIG. 3) positioned on an upper surface of the middle frame 610 as a layered structure, with the heat pipe 620 being mounted thereon.

According to an embodiment, the heat pipe 620 may be mounted on the middle frame 610, such that a heat transfer part 622 faces in a direction toward the display 640 disposed on the upper surface (for example, a surface in the +z axis direction) of the middle frame 610 as a layered structure.

According to an embodiment, the heat pipe 620 may be mounted on a fixing part (for example, the fixing part 420 of FIG. 4) of the middle frame 610, and may be disposed in the proximity of a printed circuit board 630 in the electronic device. For example, the heat pipe 620 mounted on the middle frame 610 may be disposed in the proximity of an upper surface of the printed circuit board. A position relationship between the middle frame 610 and the printed circuit board 630 may be changed.

According to an embodiment, the heat pipe 620 positioned in the proximity of the printed circuit board 630 may absorb thermal energy generated in an electronic component 660 mounted on the printed circuit board 630 through a heat transfer material 650 (for example, the heat transfer material 550 of FIG. 5). For example, the heat pipe 620 may absorb thermal energy generated from the electronic component 660 through the heat transfer material 650 which is positioned on a lower surface (for example, a surface in the -z axis direction) of the heat pipe 620. That is, the heat pipe 620 may be in contact with the electronic component 660 through the heat transfer material 650.

According to an embodiment, the heat pipe 620 may include a seating part 621 and the heat transfer part 622 to be mounted on the middle frame 610. The seating part 621 may have the same body as the heat transfer part 622, and may be seated on a coupling part 612 (for example, the coupling part 421 of FIG. 4) of the middle frame 610. In addition, a curve may be formed on the seating part 621 to include a designated angle (for example, 90 degrees) with the heat transfer part 622.

According to an embodiment, the seating parts 621 may be formed on both side surfaces of the heat transfer part 622 by compressing a part of the heat transfer part 522. The seating parts 621 may be positioned on both side surfaces of the heat transfer part 622, and may have a thickness (for example, the second thickness) which is thinner than a thickness (for example, the first thickness) of the heat transfer part 622. The seating part 621 may not have a form of a duct, which is different from the heat transfer part 622. That is, the seating part 621 may be formed by compressing at least parts of the heat transfer part 622 having the form of the duct to come into contact with each other. For example, the seating part 621 may be formed by compressing a part of the upper surface of the heat transfer part 622 and a part of the lower surface, and the area of the heat pipe 620 except for the seating part 621 formed by the compressing may include the heat transfer part 622.

According to another embodiment, the seating part 621 may diffuse heat absorbed by the heat pipe 620 through the heat transfer material 650 to a surrounding area from the heat pipe 620, according to a thermal conductivity of a material forming the heat pipe 620. An area of the heat pipe 620 that includes the seating part 621 and the heat transfer part 622 may have a thermal conductivity higher than that of an area where only the heat transfer part 622 is formed.

According to an embodiment, the heat transfer part 622 may be inserted into an area (for example, a hole) that is formed by an accommodation part 611 (for example, the accommodation part 422 of FIG. 4) of the middle frame 610. In addition, the heat transfer part 622 may include a duct through which a working fluid moves, and may be a duct that connects one end (for example, one end of FIG. 4) and the other end (for example, the other end of FIG. 4) of the heat pipe 620.

According to an embodiment, when the seating part 621 is seated on the coupling part 612, the heat transfer part 622 may be inserted into the area formed by the accommodation part 611 of the middle frame 610. That is, the fixing part included in the middle frame 610 may have a shape corresponding to the heat pipe 620, such that the heat pipe 620 is mounted while being accommodated thereon. In addition, the heat transfer part 622 may absorb thermal energy generated from the electronic component 660 mounted on the printed circuit board 630 positioned on the lower surface of the middle frame 610 as a layered structure. The heat transfer part 622 may absorb thermal energy generated in the electronic component 600 through the heat transfer material 650.

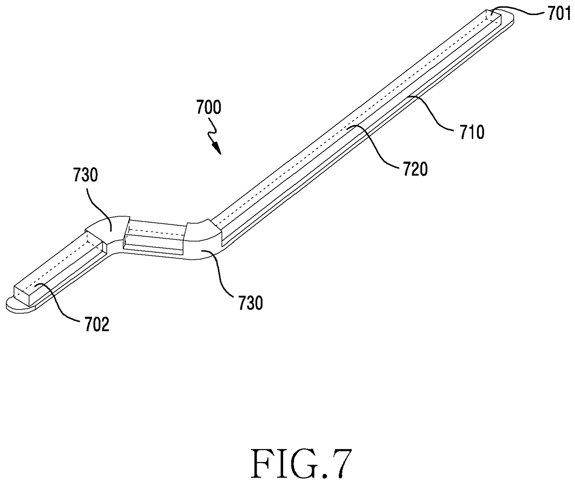

FIG. 7 is a perspective view illustrating a heat pipe having a curved shape according to an embodiment.

Referring to FIG. 7, the heat pipe 700 (for example, the heat pipe 520 of FIG. 5) may include a curved shape among various shapes. The heat pipe 700 of the curved shape may include one end 701, the other end 702, a seating part 710 (for example, the seating part 521 of FIG. 5), a heat transfer part 720 (for example, the heat transfer part 622 of FIG. 5), and a curved part 730.

According to an embodiment, the heat pipe 700 of the curved shape may include the seating part 710 and the heat transfer part 720 on an area that has a straight shape. The seating part 710 formed on the area having the straight shape may be seated on a coupling part (for example, the coupling part 421 of FIG. 4) of a middle frame (for example, the middle frame 410 of FIG. 4) included in an electronic device (for example, the electronic device 400 of FIG. 4). The heat transfer part 720 included in the area having the straight shape along with the seating part 710 may be inserted into an area that is formed by an accommodation part of the middle frame.

According to an embodiment, an area that corresponds to the curved part 730 among areas of the heat pipe 700 of the curved shape may include only the heat transfer part 720 except for the seating part 710. A fixing part (for example, the fixing part 420 of FIG. 4) of the middle frame on which the curved part 730 is mounted may be formed with an accommodation part (for example, the accommodation part 422 of FIG. 4) to accommodate the heat transfer part 720.

FIG. 8 is a cross-sectional view illustrating a state in which a seating part formed on one cross section of a heat pipe is coupled to a middle frame according to an embodiment.

Referring to FIG. 8, an electronic device (for example, the electronic device 400 of FIG. 4) may include therein a middle frame 810 (for example, the middle frame 410 of FIG. 4), a heat pipe 820 (for example, the heat pipe 440 of FIG. 4), a printed circuit board 830 (for example, the printed circuit board 340 of FIG. 3), an adhesive layer 840, a heat transfer material 850 (for example, the heat transfer material 550 of FIG. 5), an electronic component 860 (for example, the electronic component 560 of FIG. 5), a display 870 (for example, the display 101 of FIG. 1 or the display 330 of FIG. 3).

According to an embodiment, the display 870 may be disposed on an upper surface (for example, a surface in the +z axis direction) of the middle frame 810 as a layered structure.

According to an embodiment, the printed circuit board 830 may be disposed on a lower surface (for example, a surface in the -z axis direction) of the middle frame 810 as a layered structure.

According to an embodiment, the electronic component 860 may be disposed in the electronic device while being mounted on the printed circuit board 830.

According to an embodiment, the heat transfer material 850 may be positioned between the electronic component 860 and the heat pipe 820 while being coated over an upper surface of the electronic component 860.

According to an embodiment, the heat pipe 820 may be mounted on the middle frame 810. A seating part 821 included in the heat pipe 820 may be formed on a part of one side surface of both side surfaces (for example, a surface in the +x axis direction and a surface in the -z axis direction) of a heat transfer part 822, and may be integrally formed with the heat transfer part 822.

According to an embodiment, the heat pipe 820 may be mounted on the middle frame 810, such that the heat transfer part 822 faces the printed circuit board 830 which is disposed on a lower surface of the middle frame 810 as a layered structure.

According to an embodiment, the seating part 821 may be formed to have a thinner thickness than the heat transfer part 822 on a part of one side surface of both side surfaces of the heat transfer part 822. The seating part 821 may be formed by compressing the remaining width of the heat pipe 820 except for a designated width of the heat transfer part 822.

According to an embodiment, the heat pipe 820 may be mounted on a fixing part (for example, the fixing part 420 of FIG. 4) of the middle frame 810. The seating part 821 of the heat pipe 820 may be coupled with a coupling part 812 (for example, the coupling part 421 of FIG. 4) of the fixing part through the adhesive layer 840. For example, the adhesive layer 840 may be an adhesive tape, but is not limited thereto as long as the adhesive layer 840 is configured to bond the heat pipe 820 to the middle frame 810.

According to an embodiment, the fixing part of the middle frame 810 may include a structure corresponding to the seating part 821 and the heat transfer part 822 in order to couple the seating part 821 and the heat transfer part 822 of the heat pipe 820. The coupling part 812 included in the fixing part on which the heat pipe 820 is mounted may be coupled with the seating part 821 on one side surface of an accommodation part forming the fixing part.

According to an embodiment, the heat pipe including the seating part 821 on one side surface of the heat transfer part 822 may include therein a vapor channel 823 (for example, the vapor channel 523 of FIG. 5) and a wick 824 (for example, the wick 524 of FIG. 5).

According to an embodiment, the vapor channel 823 may be a duct that, when the heat pipe 820 absorbs thermal energy through the heat transfer material 850, allows a working fluid in a liquid state positioned in the heat transfer part 822 to be changed into a gaseous state and to move therethrough.

According to an embodiment, the wick 824 may be a porous structure capable of generating a capillary force in the heat transfer part 822. For example, the wick 824 may be formed with a fine metal mesh, and may be attached to an inner wall of the heat pipe 820. The wick 824 may be a passage through which the working fluid in the gaseous state dissipating all of the thermal energy on a low-temperature area is changed to the working fluid in the liquid state, and is moved. The inside of the heat pipe 820 may be in a vacuum state, and there may be a difference in pressure in the heat pipe 820 according to a state change of the working fluid, and the working fluid may be circulated in the heat transfer part 822 due to the difference in the pressure.

According to an embodiment, the heat pipe 820 having the seating part 821 formed on one side surface of both side surfaces of the heat transfer part 822 may be seated on the coupling part 812 of the middle frame through the seating part 821. The seating part 821 may be bonded and coupled to the coupling part 812 through the adhesive layer 840. The middle frame 810 positioned inside an electronic device (for example, the electronic device 400 of FIG. 4) may be disposed in the proximity of the electronic component 860 (for example, the electronic component 560 of FIG. 5) mounted on the printed circuit board (for example, the printed circuit board 530 of FIG. 5).

According to an embodiment, the heat pipe 820 mounted on the middle frame may absorb thermal energy generated in the electronic component 860 mounted on the printed circuit board 830 through one end. The heat pipe 820 may dissipate, to the low-temperature area through the working fluid in the gaseous state included in the heat transfer part 822, thermal energy absorbed through the heat transfer material 850 (for example, the heat transfer material 550 of FIG. 5) coated over the upper surface of the electronic component 860. The working fluid in the gaseous state which dissipates the thermal energy in the low-temperature area may be chanted to the working fluid in the liquid state, and may be moved to one end of the heat pipe 820 through the wick 824.

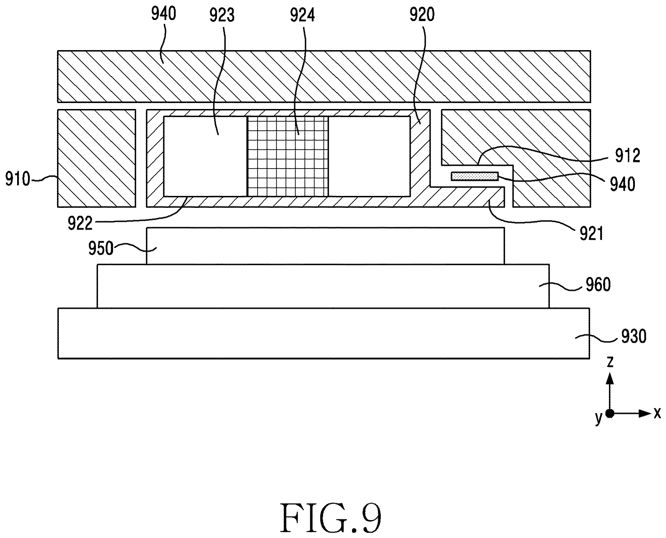

FIG. 9 is another cross-sectional view illustrating a state in which a seating part formed on one cross section of a heat pipe is coupled to a middle frame according to an embodiment.

Referring to FIG. 9, an electronic device (for example, the electronic device 400 of FIG. 4) may include therein a middle frame 910 (for example, the middle frame 410 of FIG. 4), a heat pipe 920 (for example, the heat pipe 440 of FIG. 4), a printed circuit board 930 (for example, the printed circuit board 340 of FIG. 3), an adhesive layer 940, a heat transfer material 950 (for example, the heat transfer material 550 of FIG. 5), an electronic component 960 (for example, the electronic component 560 of FIG. 5), a display 970 (for example, the display 101 of FIG. 1 or the display 330 of FIG. 3).

According to an embodiment, in the electronic device, the display 970 may be disposed on an upper surface (for example, a surface in the +z axis direction) of the middle frame 910 as a layered structure.

According to an embodiment, in the electronic device, the printed circuit board 930 may be disposed on a lower surface (for example, a surface in the -z axis direction) of the middle frame 910 as a layered structure.

According to an embodiment, the electronic component 960 may be disposed while being mounted on the printed circuit board 930.

According to an embodiment, the heat transfer material 950 may be positioned between the electronic component 960 and the heat pipe 920 while being coated over an upper surface of the electronic component 960, and may be in contact with the heat pipe 920.

According to an embodiment, the heat pipe 920 may be mounted on the middle frame 910. The heat pipe 920 may include a seating part 921 (for example, the seating part 521 of FIG. 5) and a heat transfer part 922 (for example, the heat transfer part 522 of FIG. 5). The seating part 921 may have the same body as the heat transfer part 922, and may be seated on a coupling part (for example, the coupling part 421 of FIG. 4) included in the middle frame 910. The seating part 921 may form a curve with the heat transfer part 922 and may form a predetermined angle (for example, 90 degrees). For example, the seating part 921 may form a curve in the form of " " 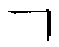 " or " 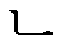 " with the heat transfer part 922. The seating part 921 may be seated on the coupling part 912 and may be bonded and coupled to the middle frame 910 through the adhesive layer 940.

According to an embodiment, the seating part 921 positioned on one side surface of both side surfaces of the heat transfer part 922 may be formed by compressing a part of the heat transfer part 922. The seating part 921 positioned on one side surface of the heat transfer part 922 may have a thickness (for example, the second thickness) thinner than a thickness (for example, the first thickness) of the heat transfer part 922. In addition, the seating part 921 may not have a form of a duct, which is different from the heat transfer part 922, and may be formed by compressing a part of an upper surface of the heat transfer part 922 and a part of a lower surface to come int contact each other.

According to an embodiment, the heat pipe 920 may be mounted on the middle frame 910, such that the heat transfer part 922 faces the display 970.

According to another embodiment, the seating part 921 may not be formed only one side surface of the heat transfer part 922, and may be formed on a certain area of both side surfaces of the heat transfer part 922.

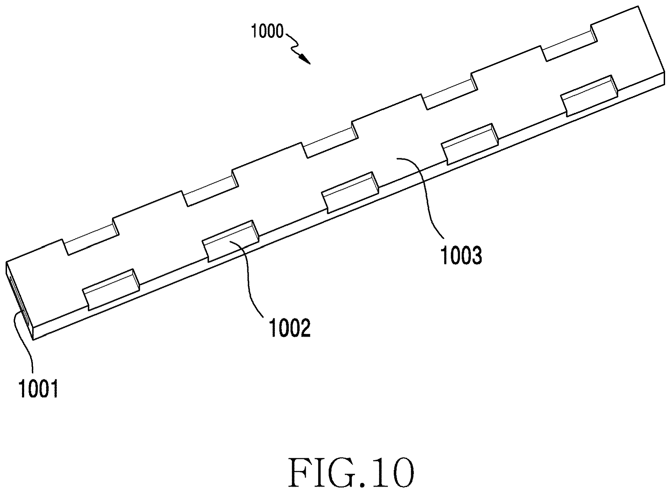

FIG. 10 is a perspective view illustrating a state in which seating parts are formed at designated intervals on a heat pipe according to an embodiment.

Referring to FIG. 10, the heat pipe 1000 (for example, the heat pipe 440 of FIG. 4) may be formed in a shape such that the seating parts 1002 (for example, the seating part 521 of FIG. 5) are formed at designated intervals among various shapes.

According to an embodiment, the seating parts 1002 may be formed at designated intervals on both side surfaces of a heat transfer part 1003 (for example, the heat transfer part 522 of FIG. 5). According to another embodiment, the seating parts 1002 may be disposed at designated intervals on a part of one side surface of both side surfaces of the heat transfer part 1003. The heat pipe 1000 may include the seating parts 1002 formed at designated intervals, and may include the heat transfer part 1003 on an area except for the seating parts 1002.

According to an embodiment, the seating part 1002 and the heat transfer part 1003 included in the heat pipe 1000 may form a curve to have a predetermined angle (for example, 90 degrees). For example, a curve may be formed on the seating part 1002 and the heat transfer part 1003 in the form of " 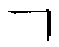 " or " 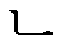 ". According to an embodiment, the remaining area except for the areas where the seating parts 1002 of the heat pipe 1000 are formed may include only the heat transfer part 1003. A fixing part (for example, the fixing part 420 of FIG. 4) of the middle frame in which the heat transfer part 1003 is accommodated may have a shape corresponding to the heat pipe 1000 including the seating parts 1002 formed at the designated intervals.

According to an embodiment, the heat pipe 1000 having the seating parts 1002 formed at the designated intervals may include a duct 1001. An internal area of the heat pipe 1000 in the area where the heat transfer part 1003 is formed may include the duct 1001 through which a working fluid moves. An internal area of the heat pipe 1000 in the area where the seating parts 1002 are formed may not include the duct 1001. A certain area of the heat pipe 1000 except for the area where the seating parts 1002 are formed may include only the heat transfer part 1003, and an internal area of the heat pipe 1000 in the area where the heat transfer part 1003 is formed may include a wick (for example, the wick 524 of FIG. 5) and a vapor channel (for example, the vapor channel 523 of FIG. 5) which are components necessary for circulating the working fluid. The wick and the vapor channel have been described in detail in FIG. 5.

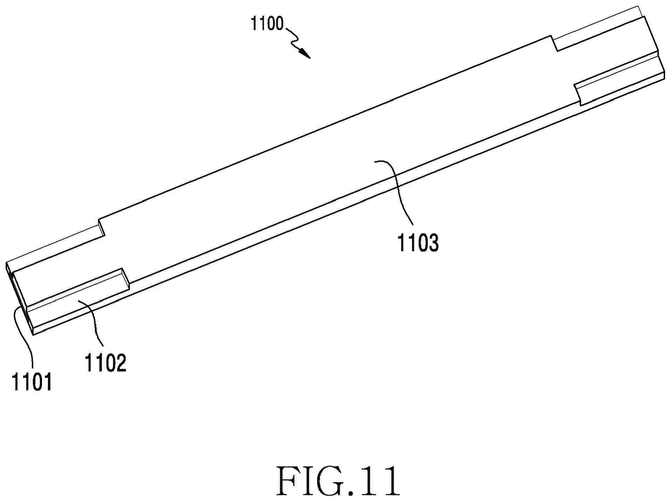

FIG. 11 is a perspective view illustrating a state in which a seating part is formed on a designated position of a heat pipe according to an embodiment.

Referring to FIG. 11, the heat pipe 1100 (for example, the heat pipe 520 of FIG. 5) may include a duct 1101, one or more seating parts 1102 (for example, the seating part 521) and a heat transfer part 1103 (for example, the heat transfer part 522 of FIG. 5).

According to an embodiment, the heat pipe 1100 may be formed to have a thin cross-section in order to maximize a contact surface with an electronic component (for example, the electronic component 560 of FIG. 5) mounted on a printed circuit board (for example, the printed circuit board 340 of FIG. 3).

According to an embodiment, the heat pipe 1100 may include the seating part 1102 on a designated area. The designated area may include a certain area of the heat pipe 1100, and the seating part 1102 may be disposed on an area adjacent to an edge of the heat pipe 1100.

According to another embodiment, the designated area of the heat pipe 1100 may be changed. According to the change of the designated area, a position of the seating part 1102 formed on the designated area may be changed.

According to an embodiment, the heat pipe 1100 may include the heat transfer part 1103 formed on the remaining area except for the designated area where the seating part 1102 is formed. An internal area of the heat pipe 1100 where the heat transfer part 1103 is formed may include the duct 1101 through which a working fluid moves. An area in the heat pipe 1100 where the seating part 1102 is formed may not include the duct 1101 in the internal area of the heat pipe 1100. A certain area of the heat pipe 1100 where the seating part 1102 is not formed may include only the heat transfer part 1103, and the internal area of the heat pipe 1100 where the heat transfer part 1103 is formed may include a wick (for example, the wick 524 of FIG. 5) and a vapor channel (for example, the vapor channel 523 of FIG. 5) which are components necessary for circulating the working fluid.

In the above-described specific embodiments of the disclosure, elements included in the disclosure are expressed in singular or plural forms according to specific embodiments. However, singular or plural forms are appropriately selected according to suggested situations for convenience of explanation, and the disclosure is not limited to a single element or plural elements. An element which is expressed in a plural form may be configured in a singular form or an element which is expressed in a singular form may be configured in plural number.

While specific embodiments have been described in the detailed descriptions of the disclosure, it will be understood by those skilled in the art that various changes may be made therein without departing from the spirit and scope of the disclosure. Therefore, the scope of the disclosure should be defined not by the described embodiments but by the appended claims or the equivalents to the claims.

## Claims

1. An electronic device comprising:
a housing comprising an internal space which is formed by a first plate facing in a first direction, and a second plate facing in a second direction opposite to the first direction;
a printed circuit board disposed in the internal space;
a middle frame disposed in the internal space in the proximity of the printed circuit board;
an electronic component mounted on the printed circuit board; and
a heat pipe fixed to the middle frame and disposed in the proximity of the printed circuit board,
wherein the heat pipe comprises:
a first end which is in contact with the electronic component through a heat transfer material;
a second end which has the same body as the first end, and is disposed at the other end corresponding to the first end;
a heat transfer part which comprises a duct of a working fluid, connects the first end and the second end, and has the same one body as the first end and the second end; and
a seating part which is formed by compressing a part of the duct, and while forming a curve with the heat transfer part, is disposed on a side surface of the heat transfer part and coupled to the middle frame.

2. The electronic device of claim 1, wherein the seating part has a second thickness which is thinner than a first thickness of the heat transfer part, and comprises a remaining width of the heat pipe except for a designated width forming the heat transfer part.

3. The electronic device of claim 1, wherein the middle frame comprises a fixing part disposed on a designated surface thereof facing the printed circuit board to allow the seating part to be coupled thereto.

4. The electronic device of claim 3, wherein the fixing part comprises:
a coupling part to which the seating part is coupled; and
an accommodation part to accommodate the heat transfer part.

5. The electronic device of claim 1, wherein the seating part does not allow the working fluid to move therethrough, and is configured to diffuse absorbed thermal energy according to a thermal conductivity of a material forming the heat pipe.

6. The electronic device of claim 1, wherein the heat transfer material comprises a material of a paste type.

7. The electronic device of claim 1, wherein, when at least a certain area of the heat pipe is curved, the heat transfer part is formed by compressing an area except for the curved part of the heat pipe.

8. The electronic device of claim 1, wherein the seating part is formed on one side surface of both side surfaces of the heat pipe.

9. The electronic device of claim 1, wherein a plurality of seating parts are formed at designated intervals on the heat pipe.

10. An electronic device comprising:
a housing comprising an internal space which is formed by a first plate facing in a first direction, and a second plate facing in a second direction opposite to the first direction;
a printed circuit board disposed in the internal space;
a first support member disposed in the internal space in the proximity of the printed circuit board;
an electronic component mounted on the printed circuit board; and
a heat dissipation member fixed to the first support member and disposed in the proximity of the printed circuit board,
wherein the heat dissipation member comprises:
a heat transfer part comprising a duct through which a working fluid absorbing thermal energy generated in the electronic component moves; and
a seating part which is formed by compressing at least a certain area of at least one side surface of the heat dissipation member among areas except for the heat transfer part, and is coupled to the first support member.

11. The electronic device of claim 10, wherein the seating part has a second thickness which is thinner than a first thickness of the heat transfer part, and forms a curve along with the heat transfer part.

12. The electronic device of claim 10, wherein the first support member comprises a fixing part disposed on a designated surface thereof facing the printed circuit board to allow the seating part to be coupled thereto.

13. The electronic device of claim 12, wherein the fixing part comprises:
a coupling part to which the seating part is coupled; and
an accommodation part to accommodate the heat transfer part.

14. The electronic device of claim 10, wherein the seating part does not allow the working fluid to move therethrough, and is configured to diffuse absorbed thermal energy according to a thermal conductivity of a material forming the heat dissipation member.

15. The electronic device of claim 10, wherein, when at least a certain area of the heat dissipation member is curved, the heat transfer part is formed by compressing an area except for the curved part of the heat dissipation member.
